# EUROPÄISCHE PATENTSCHRIFT

(11) **EP 3 865 950 B1**
(45) Veröffentlichungstag und Bekanntmachung des Hinweises auf die Patenterteilung: **23.09.2026**
(21) Anmeldenummer: 21155717.8
(22) Anmeldetag: 08.02.2021
(51) Int. Cl.: G03H 1/02, H05K 7/20, H05K 5/00, H01S 3/04, G03H 1/20, H05K 1/03

(54) **HOLOGRAMMBELICHTUNGSMASCHINE ZUM EINBRINGEN EINES VOLUMENREFLEXIONSHOLOGRAMM IN EINEN HOLOGRAMMFILM**
HOLOGRAM EXPOSURE MACHINE FOR INTRODUCING A VOLUME REFLECTION HOLOGRAM INTO A HOLOGRAM FILM
MACHINE D'EXPOSITION D'HOLOGRAMMES POUR INTRODUIRE UN HOLOGRAMME À RÉFLEXION VOLUMIQUE DANS UN FILM D'HOLOGRAMMES

(30) Priorität: 12.02.2020 DE 102020103615
(43) Veröffentlichungstag der Anmeldung: 18.08.2021
(73) Patentinhaber: Bundesdruckerei GmbH, 10969 Berlin (DE)
(72) Erfinder: Langgaßner, Michael, 81245 München (DE); Richter, Werner, 80999 München (DE)
(74) Vertreter: Hentrich Patent- & Rechtsanwaltspartnerschaft mbB

(56) Entgegenhaltungen:
- DE-A1- 102012 215 540
- US-A- 5 297 005
- US-B2- 10 305 249
- US-B2- 9 614 342

## Beschreibung

Die Erfindung betrifft eine Hologrammbelichtungsmaschine zum Einbringen eines Volumenreflexionshologramms in einen Filmabschnitt eines Hologrammfilms. Die Hologrammbelichtungsmaschine umfasst mindestens eine Lichtquelle sowie eine Strahlführungsoptik zur Führung des von der Lichtquelle emittierten Lichts. Ferner ist ein räumlicher Lichtmodulator vorhanden, der ausgebildet ist, Licht von der Lichtquelle oder von der Strahlführungsoptik zu empfangen und räumlich moduliertes Licht zurückzugeben. Zusätzlich ist ein Belichtungstisch vorhanden, welcher einen Master für die Hologrammbelichtung mittels des von dem Lichtmodulator zurückgegebenen Lichts bereitstellt.

Aus dem Stand der Technik ist es bekannt, Hologramme als Sicherheitselemente in Sicherheitsdokumente oder Wertdokumente zu integrieren. Sicherheitselemente sind solche Entitäten, welche mindestens ein Merkmal aufweisen, welches ein unautorisiertes Duplizieren, Nachahmen und/oder Verfälschen eines Gegenstands erschwert, in welchen das Sicherheitselement integriert ist. Hologramme werden als Sicherheitselemente beispielsweise in Reisepässen oder Personalausweisen verwendet. Sie werden jedoch auch in Banknoten, Führerscheinen, Visa, anderen Wertzeichen, Etiketten oder Tickets, Kreditkarten, Bankkarten, Telefonkarten oder Ähnlichem eingesetzt.

Eine besondere Gruppe von Hologrammen stellen Volumenhologramme dar. Bei einem Volumenhologramm ist eine beugende Struktur des Hologramms im Volumen des holografischen Aufzeichnungsmaterials gespeichert, wie beispielsweise den Druckschriften DE 10 2012 215 540 A1, DE 10 2007 042 385 A1 und DE 10 2007 042 386 A1 zu entnehmen ist. Als Aufzeichnungsmaterialien für Volumenhologramme werden in Wert- und/oder Sicherheitsdokumenten in der Regel holografische Belichtungsfilme eingesetzt, die zumeist auf Rollen bereitgestellt werden. Diese Belichtungsfilme sind geeignet, Interferenzstrukturen zu speichern, deren charakteristische Abmessungen im Bereich der Lichtwellenlänge des Lichts liegen, welches zur Aufzeichnung bzw. Rekonstruktion des Hologramms verwendet wird.

Bei einem Kontaktkopierverfahren wird der holografische Belichtungsfilm vor einem Master angeordnet, in dem beugende Strukturen ausgebildet sind, die in den holografischen Belichtungsfilm "übertragen" werden sollen. Die beugenden Strukturen des Masters werden beim Kontaktkopierverfahren somit in den holografischen Film kopiert. Hierfür wird kohärentes Licht durch den holografischen Film, der in unmittelbarer Nähe vor dem Master oder in Kontakt mit dem Master vor diesem angeordnet ist, auf den Master gestrahlt. Die beugenden Strukturen in dem Master beugen das Licht so, dass das gebeugte Licht in den holografischen Film zurückgestrahlt wird. Dort interferiert dieses mit dem kohärenten Licht, welches zur Beleuchtung des Masters genutzt wird. In dem holografischen Film bildet sich somit eine Interferenzstruktur aus, welche durch das an dem Master gebeugte Licht festgelegt ist. Wird der holografische Film entwickelt und rekonstruiert, so gleicht die Rekonstruktion der, die beim Beleuchten des Masters zu beobachten ist. In dem holografischen Film wird ein Hologramm gespeichert, welches auch als Denisjuk-Hologramm bezeichnet wird und ein Volumenreflexionshologramm ist. Es versteht sich, dass das eingestrahlte Licht eine geeignete Wellenlänge (oder geeignete Wellenlängen) und eine geeignete Einstrahlrichtung (oder geeignete Einstrahlrichtungen) aufweisen muss, so dass eine Beugung an der Beugungsstruktur in der gewünschten Weise erfolgt. Ein Verfahren zur Herstellung eines Masters und ein Kontaktkopierverfahren sind der EP 0 896 260 A2 zu entnehmen.

Bekannte Hologrammbelichtungsmaschinen weisen dabei Lichtquellen auf, die gegebenenfalls zusätzlich mit Netzteilen verbunden sind, wobei diese Bauteile Wärme abgeben und daher die Hologrammbelichtungsmaschine zu kühlen ist. Aufgrund der empfindlichen Strahlführungsoptik ist es daher nicht förderlich, wenn Staub umherwirbelt, beispielsweise wenn eine Kühlungsluft umgewälzt wird, insbesondere dann, wenn ein Überdruck an Luft an oder um die Konstituenten der Hologrammbelichtungsmaschine vorliegt.

Aus US 9 614 342 B2, US 5 297 005 und US 10 305 249 sind Kühlungseinheiten bekannt, um die Wärme erzeugenden elektronischen Komponenten zu kühlen. Es werden dabei vorwiegend Luftführungen beschrieben, die die Luft primär durch das Gehäuse leiten. Dadurch besteht die Gefahr, dass Staub umhergewirbelt wird.

Es ist daher die Aufgabe der vorliegenden Erfindung, eine Hologrammebelichtungsmaschine bereitzustellen, die ein verbessertes Kühlkonzept aufweist.

Diese Aufgabe wird mit einer Hologrammbelichtungsmaschine mit dem Merkmalsbestand des Anspruchs 1 gelöst. Vorteilhafte Ausgestaltungen mit zweckmäßigen Weiterbildungen der Erfindung sind in den abhängigen Ansprüchen angegeben.

Die Hologrammbelichtungsmaschine zeichnet sich dabei unter anderem dadurch aus, dass die mindestens eine Lichtquelle in einer von dem Lichtmodulator und zumindest einem Teil der Strahlführungsoptik räumlich getrennten Lichtquellenkammer untergebracht ist, die mindestens einen

Durchtritt für das von der Lichtquelle emittierte Licht umfasst. Auf diese Weise ist gewährleistet, dass diejenigen Bauteile, die die meiste Wärme beim Belichtungsprozess emittieren von der übrigen Optik, insbesondere vom Lichtmodulator thermisch entkoppelt sind. Auf diese Weise liegt ein optimiertes Kühlkonzept vor, wobei kein Überdruck für die Staubreduktion an oder um die Konstituenten der Hologrammbelichtungsmaschine mehr angelegt werden muss. umherwirbelnder Staub wird zusätzlich vermieden.

In diesem Zusammenhang ist es von Vorteil, wenn mindestens ein Netzteil vorhanden und ausgestaltet ist, die Lichtquelle elektrisch zu versorgen und/oder zu steuern, und wenn das mindestens einen Netzteil ebenfalls in der Lichtquellenkammer untergebracht ist. Auch damit sind also die Wärme emittierenden Bestandteile von den eine geringere Wärmemenge abgebenden Funktionsoptiken kammerartig oder kammerweise getrennt.

Eine wirksame Kühlung der Lichtquelle und/oder der Netzteile lässt sich dadurch hervorrufen, dass mit der Lichtquelle und/oder mit dem Netzteil ein, insbesondere mit Kühlrippen gebildeter Kühlkörper thermisch verbunden und mittels Umgebungsluft kühlbar ist.

Dabei ist die Möglichkeit gegeben, dass der Kühlkörper als ein aktiver Kühlkörper mit einem elektrisch betreibbaren Lüfterrad gebildet ist, so dass eine wirksame Kühlung der mindestens eine Lichtquelle, insbesondere des Lasers und/oder seinem Netzteil vorliegt.

Wenn eine Mehrzahl an Lichtquellen und/oder eine Anzahl der Lichtquellen entsprechende Mehrzahl an Netzteilen vorhanden ist, kann auch ein einziger Kühlkörper Einsatz finden. In diesem Zusammenhang ist es daher von Vorteil und für eine kompakte Bildung der Belichtungsmaschine sinnvoll, wenn der Kühlkörper mit einer Mehrzahl an Lichtquellen und/oder einer Mehrzahl an Netzteilen thermisch verbunden ist.

Eine zuverlässige Luftzirkulation lässt sich dadurch erzeugen, dass die Lichtquellenkammer mindestens einen Luftansaugdurchtritt aufweist, der ausgestaltet ist, Umgebungsluft in die Lichtquellenkammer eintreten zu lassen, und wenn die Lichtquellenkammer mindestens einen Luftabsaugdurchtritt aufweist, in welchem ein elektrisch angetriebenes Luftförderrad zur Förderung der Luft aus der Lichtquellenkammer an die Umgebung zugeordnet ist. Somit wird also Umgebungsluft angesaugt, durch die Kammer geführt und an den Wärme emittierenden Bestandteilen erwärmt, wodurch diese gekühlt werden. Anschließend wird durch das Luftförderrad die erwärmte Luft wieder aus der Lichtquellenkammer ausgeblasen. Für eine erhöhte Kühlungsleistung ist es von Vorteil, wenn eine Mehrzahl an Luftansaugdurchtritten und eine Mehrzahl an Luftabsaugdurchtritten mit jeweils einem eigenen elektrisch angetriebenen Luftförderrad vorhanden ist. Vorzugsweise entspricht die Anzahl der Luftansaugdurchtritte der Anzahl der Luftabsaugdurchtritte und damit der Anzahl der elektrisch angetriebenen Luftförderräder. Auf diese Weise ist eine starke Kühlleistung der Lichtquelle und/oder der etwaig vorhandenen Netzteile gegeben.

Um die sich in der Lichtquellenkammer befindlichen Konstituenten vor Verschmutzungen zu schützen, ist es vorteilhaft, wenn dem mindestens einen Luftansaugdurchtritt ein Filterelement zugeordnet ist, durch das die in die Lichtquellenkammer eintretende Luft geführt ist. Vorzugsweise ist jedem der Luftansaugdurchtritte ein entsprechendes Filterelement zugewiesen.

Es ist ferner von Vorteil, wenn in der Lichtquellenkammer eine Luftführung vorhanden ist, die ausgebildet ist, den durch den Luftansaugdurchtritt eintretenden Luftstrom zumindest anteilig, vorteilhafterweise vollständig an die Lichtquelle und/oder an ein Netzteil der Lichtquelle und/oder an einen Kühlkörper zu führen. Dabei können auch mehrere der Luftführungen vorhanden sein, um eine effiziente Kühlung aller Konstituenten innerhalb der Lichtquellenkammer bereitzustellen.

Zur Vermeidung eines Überdrucks innerhalb der Lichtquellenkammer hat es sich als sinnvoll erwiesen, wenn ein Luftdruck innerhalb der Lichtquellenkammer einem Umgebungsdruck entspricht oder hinter diesem sogar zurückbleibt. Damit liegt eine überdruckfreie Lösung zur Kühlung des Systems vor wobei der Optikbereich mit seinem Teil der Strahlführungsoptik und dem räumlichen Lichtmodulatoren frei von Luftströmungen gehalten ist.

Erfindungsgemäß sind auch der Lichtmodulator und zumindest ein Teil der Strahlführungsoptik in einer räumlich von der Lichtquellenkammer und dem Belichtungstisch getrennten Modulatorkammer untergebracht, die mindestens einen, insbesondere staubdichten Durchtritt für das vom Lichtmodulator zurückgegebenen Licht umfasst. Durch dieses weitere Kammerkonzept lassen sich die Optiken, insbesondere auch der räumliche Lichtmodulator vor Luftströmungen schützen, so dass sich dort kein umherwirbelnder Staub oder Schmutz befindet. Da es an einer entsprechenden Luftströmung innerhalb der Modulatorkammer fehlt, kann sich etwaig vorhandener Staub schlichtweg am Kammerboden absetzen, der auf einfache Weise abwischbar ist. Innerhalb der Modulatorkammer wird der Lichtstrahl, bzw. der modulierte Lichtstrahl in einer vorteilhaften Weitergestaltung aber ebenfalls gekapselt geführt. Entsprechendes ist für die Lichtführung innerhalb der Lichtquellenkammer möglich, so dass auch darin der Lichtstrahl gekapselt geführt sein kann.

Die vorliegende Erfindung wird nachfolgend anhand von Figuren näher erläutert, wobei die dargestellten Beispiele lediglich exemplarischen Charakter haben und keine Einschränkung hinsichtlich der Tragweite der beschriebenen Erfindung darstellen. Es zeigen im Einzelnen:
- Figur 1: eine schematische Darstellung einer Hologrammbelichtungsmaschine zur Belichtung eines Volumenreflexionshologramms in einen Hologrammfilm,
- Figur 2: eine Rückansicht auf einen Teil einer Hologrammbelichtungsmaschine,
- Figur 3: eine Seitenansicht ohne Abdeckung oder Türe der Lichtquellenkammer der Hologrammbelichtungsmaschine nach Figur 2, und
- Figur 4: den Schnitt entlang der Linie IV - IV aus Figur 3.

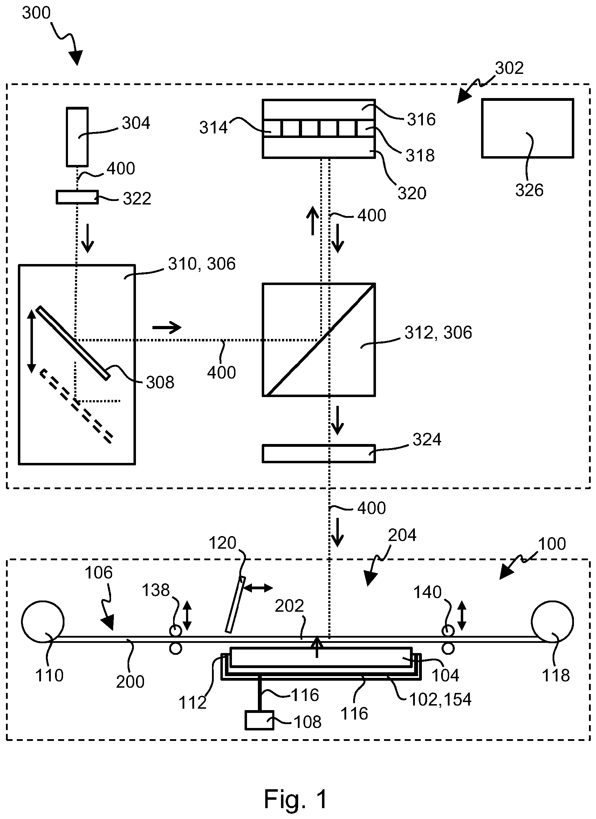

**In** Figur 1 ist schematisch eine Hologrammbelichtungsmaschine 300 zum Belichten von Hologrammen in einem Hologrammfilm 200 gezeigt. Eine solche Hologrammbelichtungsmaschine 300 wird auch als Holobelichter bezeichnet.

Die Hologrammbelichtungsmaschine 300 umfasst eine in der Zeichnung oben dargestellte Belichtungseinrichtung 302 und einen in der Zeichnung unten dargestellten Belichtungstisch 100.

Die Belichtung von Hologrammen erfolgt mittels kohärentem Licht. Hierfür weist die Belichtungeinrichtung 302 eine Lichtquelle 304 auf, welche vorliegend als ein cw-Laser ausgebildet ist. Vorliegend steht "cw" für "continuous wave" und bedeutet "zeitlich konstant abgestrahlte Welle". Es ist die Möglichkeit gegeben, dass es sich bei der Lichtquelle 304 um einen gepulsten Laser handelt. Es können auch mehrere Lichtquellen 304 vorhanden sein, die jeweils eine unterschiedliche Wellenlänge des Lichts emittieren. Das Licht 400 der als Laser ausgebildeten Lichtquelle 304 weist einen ersten Polarisationszustand auf. Zum Führen des Lichts 400 wird eine Strahlführungsoptik 306 verwendet. Das Licht der Lichtquelle 304 wird bei der dargestellten Belichtungseinrichtung 302 zunächst, ggfs. unter Zuhilfenahme einer Strahlformungseinrichtung 322 zur insbesondere in einer Raumrichtung orientierten Strahlaufweitung, auf eine Ablenk- und Scanvorrichtung 310 der Strahlführungsoptik 306 geführt. Diese Ablenk- und Scanvorrichtung 310 umfasst einen Galvanometerscanner und einen mit dem Galvanometerscanner gekoppelten Spiegel 308, an dem das einfallende Licht 400 umgelenkt wird. **In** einer ersten Stellung ist der Spiegel 308 mittels einer durchgezogenen Linie dargestellt, wobei er in einer zweiten Stellung strichliert gezeigt ist. Durch das Verschieben des Spiegels 308 kann eine einem "Scan", insbesondere einem Linienscan entsprechende Belichtung des Hologramms erfolgen. **In** anderen Worten wird der Hologrammfilm 200 zur Belichtung des Hologramms "abgetastet". Anders geartete Ablenk- und Scanvorrichtungen 310 für das Licht 400 sind ebenfalls einsetzbar.

Das abgelenkte Licht 400 wird auf einen polarisationsabhängigen Strahlteilerwürfel 312 der Strahlführungsoptik 306 geführt. Dieser ist aus einem ersten Prisma und einem zweiten Prisma gebildet, an deren Grenzfläche eine polarisationsabhängige Strahlteilung erfolgt. Anstelle von Prismen kann auch eine Strahlteilerplatte Einsatz finden. Licht 400 des ersten Polarisationszustands wird an dieser Grenzfläche abgelenkt. Licht eines weiteren, zu dem ersten Polarisationszustand orthogonalen Polarisationszustands kann hingegen durch die Grenzfläche hindurchtreten.

Das an der Grenzfläche des polarisationsabhängigen Strahlteilerwürfels 312 abgelenkte Licht 400 wird auf einen räumlichen Lichtmodulator 314 gelenkt, der als sogenannter Liquid-Crystal-on-Silicon-Lichtmodulator (LCoS) ausgebildet ist. Der Lichtmodulator 314 umfasst eine Siliziumschicht 316, an der auftreffendes Licht 400 reflektiert wird. Auf dieser Siliziumschicht 316 sind vorliegend elektronische Schaltelemente ausgebildet, die zum Schalten von Flüssigkristallzellen 318 verwendet werden, die vor der zur Reflexion genutzten Oberfläche der Siliziumschicht 316 angeordnet sind. Die einzelnen Flüssigkristallzellen 318 können individuell in unterschiedliche Schaltzustände versetzt werden. Typischerweise liegt ein Array an Flüssigkristallzellen 318 vor, so dass aus der Papierebene heraus oder in diese hinein versetzt weitere Reihen an Flüssigkristallzellen 318 vorliegen. Abhängig von dem jeweiligen Schaltzustand der Flüssigkristallzellen 318 wird ein Polarisationszustand des durchtretenden Lichts 400 geändert oder nicht geändert, wodurch das Licht 400 räumlich moduliert wird. Vereinfachend wird hier angenommen, dass in einem ersten Schaltzustand das in einem ersten Polarisationszustand auf den Lichtmodulator 314 auftreffende Licht 400 beim Durchtritt durch eine Flüssigkristallzelle 318, welche aufgrund der Reflexion an der Oberfläche der Siliziumschicht 316 zweimal durchlaufen wird, insgesamt hinsichtlich der Polarisation so verändert wird, dass das Licht 400 anschließend in dem zu dem ersten Polarisationszustand orthogonalen weiteren Polarisationszustand polarisiert ist. Dieses hinsichtlich der Polarisation modulierte Licht 400 tritt durch eine transparente Schutzscheibe 320 des räumlichen Lichtmodulators 314, wobei insbesondere eine Austrittsfläche der Schutzscheibe 320 parallel zu der Reflexionsoberfläche der Siliziumschicht 316 orientiert ist. Die Oberflächennormale des Lichtmodulators 314 ist somit orthogonal sowohl zu der Austrittsfläche der Schutzscheibe 320 als auch zu der reflektierenden Oberfläche der Siliziumschicht 316.

Das modulierte Licht trifft nach dem Austreten aus dem Lichtmodulator 314 erneut auf dem polarisationsabhängigen Strahlteiler 312 auf, wobei das vom LCoS zurückreflektierte modulierte Licht 400 abhängig von seinem Polarisationszustand die Grenzfläche des Strahlteilers 312 passieren kann oder nicht. Ist das modulierte Licht 400, wie im exemplarisch dargestellten Fall, aufgrund des ersten Schaltzustands der Flüssigkristallzelle in den zu dem ersten Polarisationszustand orthogonalen weiteren Polarisationszustand überführt worden, so kann dieses die Grenzfläche des polarisationsabhängigen Strahlteilerwürfels 312 passieren, womit es, ggfs. unter Zuhilfenahme eines Polarisationsfilters 324, weiter in Richtung des Belichtungstisches 100 geleitet wird. Anteile des Lichts 400, die sich nach wie vor in dem ersten Polarisationszustand befinden und an dem polarisationsabhängigen Strahlteilerwürfel 312 ankommen, werden an dessen Grenzfläche abgelenkt und gelangen daher nicht weiter in Richtung des sich unter der Belichtungseinrichtung 302 befindlichen Belichtungstisches 100. Durch den polarisationsabhängigen Strahlteilerwürfel 312 wird somit das Licht 400 abhängig von dem aufmodulierten Polarisationszustand räumlich hinsichtlich der Intensität moduliert.

Bei der Beschreibung der Belichtungseinrichtung 302 wurde bis hierher davon ausgegangen, dass der räumliche Lichtmodulator 314 den Polarisationszustand des Lichts um 90 Grad dreht oder unverändert lässt. Es sind jedoch auch Änderungen möglich, die eine Drehung der Polarisationsrichtung zwischen 0 Grad und 90 Grad bewirken. Alle diese Drehungen führen dazu, dass das Licht eine veränderte Amplitude und damit veränderte Intensität des weiteren Polarisationszustands aufweist. Je nach Drehwinkel variieren diese und nehmen mit dem Betrag der Drehung zwischen 0 Grad und 90 Grad zu. Hierdurch ist es möglich "Graustufen" zu belichten.

Der Belichtungstisch 100 weist eine Halteeinrichtung 102 auf, in welcher ein Master 104 aufgenommen ist. Der Master 104 umfasst einen Träger, welcher in der Regel aus Glas oder einem anderen Werkstoff gebildet ist. Auch andere Trägermaterialien sind möglich, beispielsweise Metalle. Auf den Träger ist vorzugsweise mindestens eine optisch aktive Schicht, beispielsweise eine Beugungsschicht, aufgebracht, welche eine zu kopierende Beugungsstruktur umfasst. Vorliegend umfasst die Beugungsschicht des Masters 104 ein Volumenreflexionshologramm, welches kopiert werden soll.

Es ist zu erkennen, dass die Belichtungsmaschine 300, insbesondere der Belichtungstisch 100 eine Filmtransporteinrichtung 106 umfasst, die ausgebildet ist, den Hologrammfilm 200 relativ bezüglich der Halteeinrichtung 102 und damit relativ zum Master 104 zu transportieren. Die Filmtransporteinrichtung 106 ist für ein Aufnehmen des holografischen Films und Halten und/oder Führen des Films während der Belichtung des Hologramms vorgesehen. Bei der dargestellten Belichtungsmaschine 300 umfasst die Filmtransporteinrichtung 106 eine Filmrolle 110, auf der der Hologrammfilm 200 bereitgestellt wird. Dieser wird nach dem Belichten auf einer weiteren Filmrolle 118 aufgewickelt. Gegebenenfalls durchläuft der belichtete Hologrammfilm 200 eine Strecke zur Entwicklung des Hologramms, durch welche thermisch auf den Hologrammfilm 200 eingewirkt wird, um das Hologramm im Film zu fixieren, bevor der belichtete Hologrammfilm 200 auf der weiteren Filmrolle 118 wieder aufgewickelt wird. Der Hologrammfilm 200 wird jedenfalls in typischer Weise mittels Filmführungsrollen geführt. Es ist zu erkennen, dass sich der Hologrammfilm 200 über den Bereich des Masters 104 hinweg erstreckt, womit die Filmtransporteinrichtung 106 in anderen Worten also ausgebildet ist, einen zu belichtenden Filmabschnitt 202 relativ bezüglich des Masters 104 zu positionieren. **In** diesen Filmabschnitt 202 wird das Volumenreflexionshologramm belichtet, mithin einkopiert. Um eine betriebssichere Belichtung des Hologramms zu erzielen, liegt der Hologrammfilm 200 während des Belichtungsvorgangs an dem Master 104 an. Durch diese Anlage lassen sich Eigenbewegungen des holografischen Films unterdrücken, was die erzielbare Beugungseffizienz des hergestellten Hologramms steigert.

Bei der Belichtung tritt das modulierte Licht 400, welches den weiteren Polarisationszustand aufweist, durch den zu belichtenden Filmabschnitt 202 des Hologrammfilms 200 hindurch und wird an der optisch aktiven Struktur der mindestens einen optisch aktiven Schicht des Masters 104 zurückgelenkt, z.B. bei einer als Beugungsschicht ausgebildeten optisch aktiven Schicht gebeugt. Das zurückgestrahlte Licht (nicht dargestellt) interferiert dann in dem Hologrammfilm 200 mit dem von dem Lichtmodulator 314 kommenden modulierten Licht 400. Hierdurch wird die optisch aktive Struktur, z.B. die beugende Struktur, des Masters 104 in den Hologrammfilm 200 einbelichtet. Hierbei wird die optisch aktive Struktur pixelweise abhängig von der räumlichen Modulation entweder belichtet und kopiert oder andererseits nicht belichtet und somit auch nicht kopiert. Es entsteht somit eine Kopie der optisch aktiven Struktur, beispielsweise eine Kopie eines Volumenreflexionshologramms einer Mattscheibe.

Der Halteeinrichtung 102 ist vorliegend eine Drucklufteinrichtung 108 zugeordnet, die ausgebildet ist, für die Belichtung des Filmabschnitts 202 diesen mittels eines Unterdrucks an dem in der Halteeinrichtung 102 aufgenommenen Master 104 zumindest zeitweise zu fixieren. Hierzu ist vorliegend ein um den Master 104 umfangsseitig angeordneter Schlitz vorhanden, der somit eine Gasdurchtrittsanordnung 112 bildet. Die Gasdurchtrittsanordnung 112 rahmt also den Master 104 umfangsseitig und gewährleistet damit ein blasenfreies Anliegen des zu belichtenden Filmabschnitts 202 am Master 104. Vorliegend kann die Drucklufteinrichtung 108 aber zusätzlich dazu genutzt werden, um zeitweise einen Überdruck derart bereitzustellen, dass der Transport des Hologrammfilms 200 relativ bezüglich des Masters 104 von einem Luftpolster gestützt erfolgt, was Beschädigungen des Hologrammfilms 200 zusätzlich vorbeugt.

Um Gaseinschlüsse zwischen dem Hologrammfilm 200 und dem Master 104 zusätzlich herausdrücken zu können, ist vorliegend außerdem eine Aufstreifeinrichtung 120 vorhanden um den zu belichtenden Filmabschnitt 202 auf den Master 104 aufzustreifen. Diese Aufstreifeinrichtung 120 ist vorliegend durch einen zwischen zwei Anschlägen verschiebbaren Schlitten gebildet, an dem eine auf einer Drehachse drehbar gelagerte und beim Aufstreifen mit dem Filmabschnitt 202 wechselwirkende Anpressrolle gelagert ist.

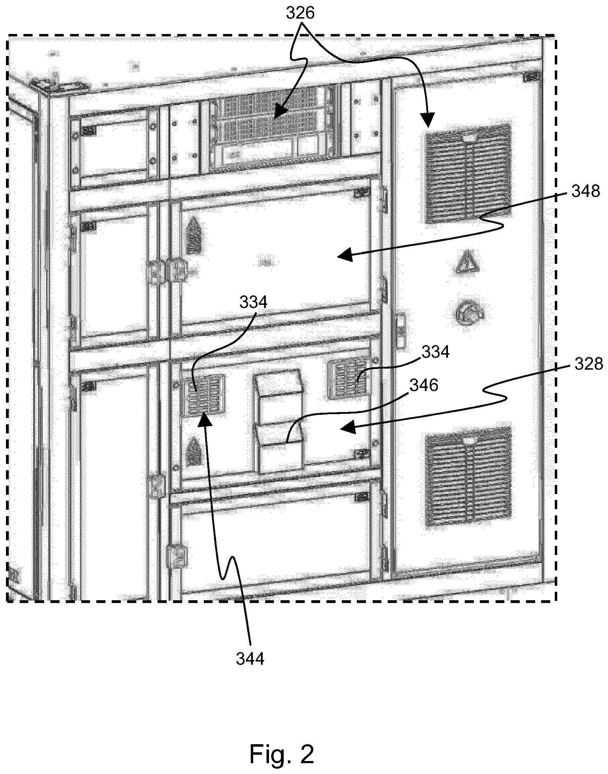

Die vorliegende Erfindung beschäftigt sich mit der gegenseitigen Anordnung der Konstituenten der Hologrammbelichtungsmaschine 300, wobei ausweislich Figur 2 die mindestens eine Lichtquelle 304 in einer von dem Lichtmodulator 314 und zumindest einem Teil der Strahlführungsoptik 306 räumlich getrennten Lichtquellenkammer 328 untergebracht ist, die mindestens einen, insbesondere gasdichten Durchtritt für das von der Lichtquelle 304 emittierte Licht umfasst. Vorliegend ist auch der Lichtmodulator 314 und zumindest ein Teil der Strahlführungsoptik 306 in einer räumlich von der Lichtquellenkammer 328 und dem Belichtungstisch 100 getrennten Modulatorkammer 348 untergebracht, wobei die Modulatorkammer 348 mindestens einen, insbesondere gasdichten Durchtritt für das vom Lichtmodulator 314 zurückgegebenen Licht 400 in Richtung des Belichtungstisches 100 umfasst. Zusätzlich ist eine gesondert gekammerte oder gekapselte Steuerungseinrichtung 326 vorhanden, die ausgebildet ist, die mindestens eine Lichtquelle 304 und/oder die Ablenk- und Scaneinrichtung 310 und/oder den Lichtmodulator 314 und/oder die Filmtransporteinrichtung 106 und/oder die Drucklufteinrichtung 108 und/oder die Aufstreifeinrichtung 120 und/oder mindestens einen Lüfter- oder Luftförderräder 334, 340 zu steuern. Zusätzlich ist über der Modulatorkammer 348 außerdem ein PC-Bereich vorhanden, der ebenfalls mit einer eigenständigen Luftkühlung ausgestattet ist.

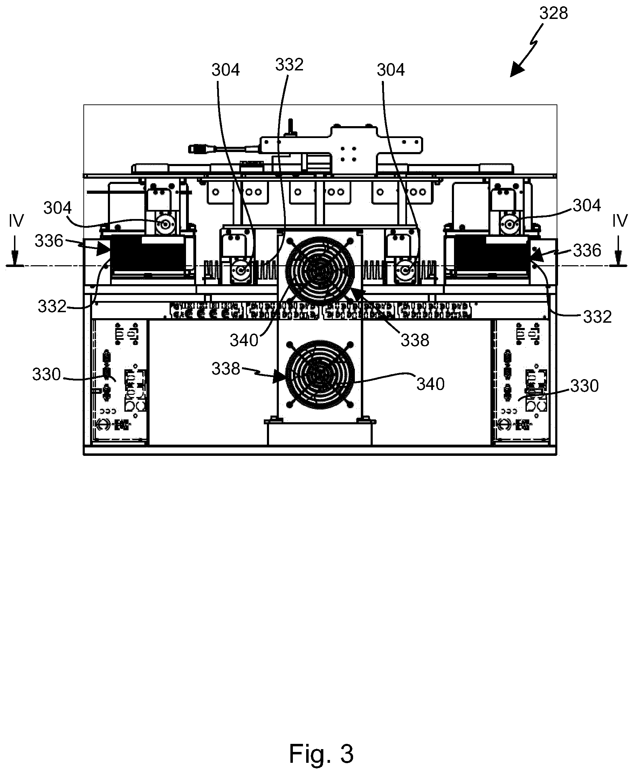

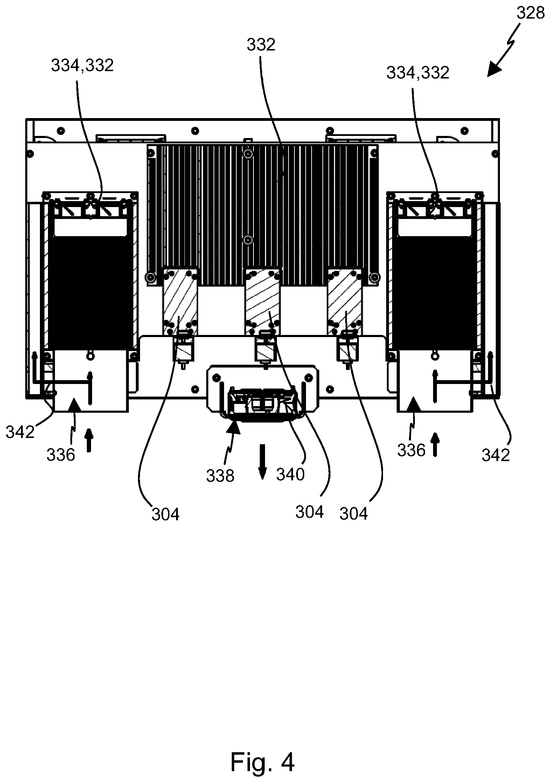

In Figuren 3 und 4 ist die Lichtquellenkammer 328 näher gezeigt, jedoch ohne ihre Abdeckung. Dabei ist zu erkennen, dass mehrere Lichtquellen 304 in Form von Lasern vorhanden sind, wobei jedem Laser ein eigenes Netzteil 330 zugewiesen ist. Diese Laser und ihre Netzteile 330 emittieren Wärme, so dass deren Kühlung erforderlich ist, um ein Überhitzen und um eine thermisch induzierte Ungenauigkeit der Strahlführungen zu vermeiden. Da die Netzteile 330 ebenfalls in der Lichtquellenkammer 328 untergebracht sind, genügt eine einzige Kühlungseinrichtung um sowohl die Laser als auch deren Netzteile 330 zu kühlen. Dabei sind die beiden randseitig dargestellten Lichtquellen 304 mit einem aktiven Kühlkörper 332 thermisch verbunden, welcher jeweils ein elektrisch betreibbares Lüfterrad 334 umfasst. Die sich zwischen den außenliegenden Lichtquellen 304 befindlichen Lichtquellen 304, welche vorliegend durch drei Laser gekennzeichnet sind, sind ebenfalls mit einem mit Kühlrippen gebildeten Kühlkörper 332 thermisch verbunden, der ebenfalls mittels Umgebungsluft gekühlt wird. Der zentral dargestellte Kühlkörper 332 ist dabei selbst mit einer Mehrzahl an Lichtquellen 304 und mit einer Mehrzahl an Netzteilen 330 thermisch verbunden.

Es ist zu erkennen, dass sie Lichtquellenkammer 328 vorliegend zwei Luftansaugdurchtritte 336 aufweist, die ausgebildet sind, Umgebungsluft in die Lichtquellenkammer 328 eintreten zu lassen. Dabei ist zu erkennen, dass jeder der Luftansaugdurchtritte 336 ein zusätzlicher Bypass zugewiesen ist, um einen Anteil der Luftströmung unmittelbar an den zentral angeordneten, passiven Kühlkörper 332 zu führen. Der andere, komplementäre Anteil der Luftströmung wird durch den jeweiligen aktiven Kühlkörper 332 der außenliegenden Lichtquellen 304 verwertet. Diese Bypässe bilden dabei also eine geeignete Luftführung 342, die ausgebildet ist, den durch den Luftansaugdurchtritt 336 eintretenden Luftstrom zumindest anteilig an die Lichtquelle 304 und/oder an ein Netzteil 330 der Lichtquelle 304 und/oder an den Kühlkörper 332 zu führen. Die Ansaugung des Luftstroms der Umgebungsluft erfolgt dabei vorliegend mittels mehrerer elektrisch angetriebener Luftförderräder 340, die sich zentral, d.h. zwischen den Luftansaugdurchtritten 336 befinden. Diese Luftförderräder 340 sind jeweils einem Luftabsaugdurchtritt 338 zugeordnet, durch die mittels der Luftförderräder 340 die Luft aus der Lichtquellenkammer 328 an die Umgebung gefördert wird. In diesem Fall liegt eine überdruckfreie Lösung zur Kühlung der Lichtquellenkammer 328 vor, die mittels Umgebungsluft oder Raumluft erfolgt. Mit anderen Worten entspricht also ein Luftdruck innerhalb der Lichtquellenkammer 328 einem Umgebungsdruck oder bleibt sogar hinter diesem zurück.

Wie sich wiederum Figur 2 entnehmen lässt, ist zum Schutz vor Schmutz oder Staub jedem der Luftansaugdurchtritte 336 ein Filterelement 344 zugeordnet, durch das die in die Lichtquellenkammer 328 eintretende Luft geführt ist, bevor sie an die Lichtquelle 304 oder deren Netzteile 330 gelangt. Vorzugsweise ist auch jeder Luftabsaugdurchtritt 338 mit einer Blende 346 versehen, so dass der austretende Luftstrom aus der Lichtquellenkammer 328 eine Ablenkung erfährt und nicht ungehindert austritt.

Mit der vorliegenden Erfindung ist ein Kammerkonzept geschaffen, das eine Kühlung mittels Umgebungsluft erlaubt. Dabei sind alle diejenigen Konstituenten der Hologrammbelichtungsmaschine 300 in einer gemeinsamen Kammer, nämlich der Lichtquellenkammer 328 angeordnet, die einer größeren Kühlung bedürfen. Die räumliche Trennung der Optiken, insbesondere der Lichtmodulatoren 314, führt dazu, dass diese keinen Luftstrom abbekommen und damit kein umherwirbelnder Staub oder Schmutz vorliegt, der die Hologrammbelichtung negativ beeinflussen könnte.

### BEZUGSZEICHENLISTE

- 100: Belichtungstisch
- 102: Halteeinrichtung
- 104: Master
- 106: Filmtransporteinrichtung
- 108: Drucklufteinrichtung (Saugeinrichtung und/oder Blaseinrichtung)
- 110: Filmrolle (unbelichteter Holofilm)
- 112: Gasdurchtrittsanordnung
- 116: Kanal (Druckluft/Saugluft)
- 118: weitere Filmrolle (belichteter Holofilm)
- 120: Aufstreifeinrichtung
- 138: erste Filmhubeinrichtung
- 140: zweite Filmhubeinrichtung
- 200: Hologrammfilm
- 202: Filmabschnitt (zu belichtender Filmabschnitt)
- 300: Hologrammbelichtungsmaschine
- 302: Belichtungseinrichtung
- 304: Lichtquelle (z.B. Laser)
- 306: Strahlführungsoptik
- 308: Spiegel
- 310: Ablenk- und Scaneinrichtung
- 312: Strahlteiler
- 314: Lichtmodulator
- 316: Siliziumschicht
- 318: Flüssigkristallzelle
- 320: Schutzscheibe
- 322: Strahlformungseinrichtung (z.B. Powell- oder Zylinderlinse)
- 324: Polarisationsfilter
- 326: Steuerungseinrichtung
- 328: Lichtquellenkammer
- 330: Netzteil
- 332: Kühlkörper
- 334: Lüfterrad
- 336: Luftansaugdurchtritt
- 338: Luftabsaugdurchtritt
- 340: Luftförderrad
- 342: Luftführung
- 344: Filterelement
- 346: Blende
- 348: Modulatorkammer
- 400: Licht

## Patentansprüche

1. Hologrammbelichtungsmaschine (300) zum Einbringen eines Volumenreflexionshologramms in einen Filmabschnitt (202) eines Hologrammfilms (200),
mit mindestens einer Lichtquelle (304),
mit einer Strahlführungsoptik (306) zur Führung des von der Lichtquelle (304) emittierten Lichts (400),
mit einem räumlichen Lichtmodulator (314) in Form eines Liquid-Crystal-on-Silicon-Lichtmodulators, der ausgebildet ist, Licht (400) von der Lichtquelle (304)
oder von der Strahlführungsoptik (306) zu empfangen und räumlich moduliertes Licht (400) durch Reflektieren an einer Siliziumschicht (316) zurückzugeben,
sowie mit einem Belichtungstisch (100), welcher einen Master (104) für die Hologrammbelichtung mittels des vom Lichtmodulator (314) zurückgegebenen Lichts (400) bereitstellt,
**dadurch gekennzeichnet, dass**
die mindestens eine Lichtquelle (304) in einer von dem Lichtmodulator (314) und zumindest einem Teil der Strahlführungsoptik (306) räumlich getrennten Lichtquellenkammer (328) untergebracht ist, die mindestens einen Durchtritt für das von der Lichtquelle (304) emittierte Licht (400) umfasst, und
dass der Lichtmodulator (314) und zumindest ein Teil der Strahlführungsoptik (306) in einer räumlich von der Lichtquellenkammer (328) und dem Belichtungstisch (100) getrennten Modulatorkammer (348) untergebracht sind, die mindestens einen Durchtritt für das vom Lichtmodulator (314) zurückgegebene Licht (400) umfasst.

2. Hologrammbelichtungsmaschine (300) nach Anspruch 1, **dadurch gekennzeichnet, dass** mindestens ein Netzteil (330) vorhanden und ausgestaltet ist, die Lichtquelle (304) elektrisch zu versorgen und/oder zu steuern, und dass das mindestens eine Netzteil (330) ebenfalls in der Lichtquellenkammer (328) untergebracht ist.

3. Hologrammbelichtungsmaschine (300) nach Anspruch 1 oder 2, **dadurch gekennzeichnet, dass** mit der Lichtquelle (304) und/oder mit dem Netzteil (330) ein Kühlkörper (332) thermisch verbunden und mittels Umgebungsluft kühlbar ist.

4. Hologrammbelichtungsmaschine (300) nach Anspruch 3, **dadurch gekennzeichnet, dass** der Kühlkörper (332) als ein aktiver Kühlkörper (332) mit einem elektrisch betreibbaren Lüfterrad (334) gebildet ist.

5. Hologrammbelichtungsmaschine (300) nach Anspruch 3 oder 4, **dadurch gekennzeichnet, dass** der Kühlkörper (332) mit einer Mehrzahl an Lichtquellen (304) und/oder einer Mehrzahl an Netzteilen (330) thermisch verbunden ist.

6. Hologrammbelichtungsmaschine (300) nach einem der Ansprüche 1 bis 5, **dadurch gekennzeichnet, dass** die Lichtquellenkammer (328) mindestens einen Luftansaugdurchtritt (336) aufweist, der ausgebildet ist, Umgebungsluft in die Lichtquellenkammer (328) eintreten zu lassen, und dass die Lichtquellenkammer (328) mindestens einen Luftabsaugdurchtritt (338) aufweist, welchem ein elektrisch angetriebenes Luftförderrad (340) zur Förderung der Luft aus der Lichtquellenkammer (328) an die Umgebung zugeordnet ist.

7. Hologrammbelichtungsmaschine (300) nach Anspruch 6, **dadurch gekennzeichnet, dass** dem mindestens einen Luftansaugdurchtritt (336) ein Filterelement (344) zugeordnet ist, durch das die in die Lichtquellenkammer (328) eintretende Luft geführt ist.

8. Hologrammbelichtungsmaschine (300) nach Anspruch 6 oder 7, **dadurch gekennzeichnet, dass** in der Lichtquellenkammer (328) eine Luftführung (342) vorhanden ist, die ausgebildet ist, den durch den Luftansaugdurchtritt (336) eintretenden Luftstrom zumindest anteilig an die Lichtquelle (304) und/oder an ein Netzteil (330) der Lichtquelle (304) und/oder an einen Kühlkörper (332) zu führen.

9. Hologrammbelichtungsmaschine (300) nach einem der Ansprüche 1 bis 8, **dadurch gekennzeichnet, dass** ein Luftdruck innerhalb der Lichtquellenkammer (328) einem Umgebungsdruck entspricht oder hinter diesem zurückbleibt.

## Claims

1. A hologram exposure machine (300) for forming a volume reflection hologram in a film section (202) of a hologram film (200),
with at least one light source (304),
with a beam-guiding optical system (306) for guiding the light (400) emitted by the light source (304),
with a spatial light modulator (314) in the form of a liquid-crystal-on-silicon light modulator, which is configured to receive light (400) from the light source (304) or from the beam-guiding optics (306) and to return spatially modulated light (400) by reflection off a silicon layer (316),
and with an exposure table (100) that provides a master (104) for hologram exposure using the light (400) returned by the light modulator (314),
**characterized in that**
the at least one light source (304) is housed in a light source chamber (328) spatially separated from the light modulator (314) and at least a portion of the beam-guiding optics (306), which comprises at least one aperture for the light (400) emitted by the light source (304), and
that the light modulator (314) and at least a portion of the beam-guiding optics (306) are housed in a modulator chamber (348) spatially separated from the light source chamber (328) and the exposure table (100), which comprises at least one passage for the light (400) reflected by the light modulator (314).

2. The hologram exposure machine (300) according to claim 1, **characterized in that** at least one power supply unit (330) is provided and configured to supply power to and/or control the light source (304), and that the at least one power supply unit (330) is also housed in the light source chamber (328).

3. The hologram exposure machine (300) according to claim 1 or 2, **characterized in that** a heat sink (332) is thermally connected to the light source (304) and/or the power supply unit (330) and can be cooled by ambient air.

4. The hologram exposure machine (300) according to claim 3, **characterized in that** the heat sink (332) is configured as an active heat sink (332) with an electrically driven fan (334).

5. The hologram exposure machine (300) according to claim 3 or 4, **characterized in that** the heat sink (332) is thermally connected to a plurality of light sources (304) and/or a plurality of power supplies (330).

6. The hologram exposure machine (300) according to any one of claims 1 to 5, **characterized in that** the light source chamber (328) comprises at least one air intake passage (336) configured to allow ambient air to enter the light source chamber (328), and that the light source chamber (328) comprises at least one air exhaust passage (338), to which an electrically driven air impeller (340) is associated for conveying the air from the light source chamber (328) to the environment.

7. The hologram exposure machine (300) according to claim 6, **characterized in that** a filter element (344) is associated with the at least one air intake passage (336), through which the air entering the light source chamber (328) is guided.

8. The hologram exposure machine (300) according to claim 6 or 7, **characterized in that** an air duct (342) is provided in the light source chamber (328), which is configured to direct the air flow entering through the air intake passage (336) at least partially to the light source (304) and/or to a power supply (330) of the light source (304) and/or to a heat sink (332).

9. The hologram exposure machine (300) according to any one of claims 1 to 8, **characterized in that** the air pressure within the light source chamber (328) corresponds to ambient pressure or is lower than ambient pressure.

## Revendications

1. Machine d'exposition d'hologramme (300) pour l'introduction d'un hologramme par réflexion en volume dans une section de film (202) d'un film d'hologramme (200),
avec au moins une source de lumière (304),
avec une optique de guidage de faisceau (306) pour le guidage de la lumière (400) émise par la source de lumière (304),
avec un modulateur de lumière (314) spatial sous la forme d'un modulateur de lumière à cristaux liquides sur silicone qui est formé afin de recevoir de la lumière (400) de la source de lumière (304) ou de l'optique de guidage de faisceau (306) et de rendre la lumière (400) modulée dans l'espace par réflexion sur une couche de silicium (316),
ainsi qu'avec une table d'exposition (100) qui fournit un maître (104) pour l'exposition d'hologramme au moyen de la lumière (400) rendue par le modulateur de lumière (314),
**caractérisée en ce que**
l'au moins une source de lumière (304) est logée dans une chambre de source de lumière (328) séparée dans l'espace du modulateur de lumière (314) et au moins d'une partie de l'optique de guidage de faisceau (306), chambre qui comprend au moins un passage pour la lumière (400) émise par la source de lumière (304) et
le modulateur de lumière (314) et au moins une partie de l'optique de guidage de faisceau (306) sont logés dans une chambre de modulateur (348) séparée dans l'espace de la chambre de source de lumière (328) et la table d'exposition (100), chambre qui comprend au moins un passage pour la lumière (400) rendue par le modulateur de lumière (314).

2. Machine d'exposition d'hologramme (300) selon la revendication 1, **caractérisée en ce qu'**au moins un bloc d'alimentation (330) est présent et configuré afin d'alimenter électriquement et/ou de commander la source de lumière (304), et **en ce que** l'au moins un bloc d'alimentation (330) est également logé dans la chambre de source de lumière (328).

3. Machine d'exposition d'hologramme (300) selon la revendication 1 ou 2, **caractérisée en ce qu'**un corps de refroidissement (332) est thermiquement relié à la source de lumière (304) et/ou au bloc d'alimentation (330) et peut être refroidi par de l'air ambiant.

4. Machine d'exposition d'hologramme (300) selon la revendication 3, **caractérisée en ce que** le corps de refroidissement (332) est formé comme un corps de refroidissement (332) actif avec une roue de ventilateur (334) pouvant fonctionner de manière électrique.

5. Machine d'exposition d'hologramme (300) selon la revendication 3 ou 4, **caractérisée en ce que** le corps de refroidissement (332) est thermiquement relié à une pluralité de sources de lumière (304) et/ou à une pluralité de blocs d'alimentation (330).

6. Machine d'exposition d'hologramme (300) selon l'une quelconque des revendications 1 à 5, **caractérisée en ce que** la chambre de source de lumière (328) présente au moins un passage d'aspiration d'air (336) qui est formé afin de laisser entrer de l'air ambiant dans la chambre de source de lumière (328), et **en ce que** la chambre de source de lumière (328) présente au moins un passage d'aspiration d'air (338), auquel est associée une roue de transport d'air (340) entraînée de manière électrique pour le transport d'air de la chambre de source de lumière (328) vers l'environnement.

7. Machine d'exposition d'hologramme (300) selon la revendication 6, **caractérisée en ce qu'**un élément de filtre (344) est associé à l'au moins un passage d'aspiration d'air (336), lequel élément est traversé par l'air entrant dans la chambre de source d'air (328).

8. Machine d'exposition d'hologramme (300) selon la revendication 6 ou 7, **caractérisée en ce qu'**un guidage d'air (342) est présent dans la chambre de source de lumière (328), lequel est formé afin de guider le courant d'air entrant par le passage d'aspiration d'air (336) au moins proportionnellement à la source de lumière (304) et/ou à un bloc d'alimentation (330) de la source de lumière (304) et/ou à un corps de refroidissement (332).

9. Machine d'exposition d'hologramme (300) selon l'une quelconque des revendications 1 à 8, **caractérisée en ce qu'**une pression d'air dans la chambre de source de lumière (328) correspond à une pression ambiante ou reste en deçà de celle-ci.
